# EUROPEAN PATENT SPECIFICATION

(11) **EP 3 242 371 B1**
(45) Date of publication and mention of the grant of the patent: **29.01.2020**
(21) Application number: 16204092.7
(22) Date of filing: 14.12.2016
(51) Int. Cl.: H02J 3/36, G01R 31/02

(54) **APPARATUS FOR PREDICTING POWER LOSS OF TRANSFORMER**
VORRICHTUNG ZUR VORHERSAGE DES LEISTUNGSVERLUSTS EINES TRANSFORMATORS
APPAREIL PERMETTANT DE PRÉVOIR LA PERTE DE PUISSANCE DE TRANSFORMATEUR

(30) Priority: 04.05.2016 KR 20160055739
(43) Date of publication of application: 08.11.2017
(73) Proprietor: LSIS Co., Ltd., Gyeonggi-do 14119 (KR)
(72) Inventor: LEE, Seung-Wook, 14118 Gyeonggi-do (KR)
(74) Representative: K&L Gates LLP

(56) References cited:
- EP-A1- 1 786 083
- JP-A- 2009 246 249
- RU-C1- 2 563 331

## Description

### BACKGROUND

### 1. Technical Field

The present disclosure relates to an apparatus for predicting a power loss of a transformer, and an apparatus for predicting power loss of a transformer capable of predicting a power loss by comparing temperature data of a transformer with reference data thereof.

### 2. Description of the Related Art

A connection manner in an electric power system includes a connection manner in which conventional alternating current (AC) electric power systems are directly connected to each other, and a connection manner in which systems are connected to each other by converting AC electric power into direct current (DC) electric power. Recently, there is a growing tendency to an interest in the connection manner in which systems are connected to each other by converting AC electric power into DC electric power rather than the connection manner in which AC electric power systems are directly connected to each other. In Korea, electrical power systems between Jeju and Haenam are connected to each other by installing a high voltage direct current (HVDC) system using an electric power converter.

A HVDC transmission method is one of electricity transmission methods, and is a supply method in which high voltage AC electric power generated at a power plant is transmitted by being converted into DC electric power and then the DC electric power is reconverted into AC electric power at a power receiving region. The HVDC transmission method uses a DC voltage. Because a DC voltage has a magnitude of about only 70% compared to a maximum value of an AC voltage, the HVDC transmission system may be easy in insulation of devices and the number of insulators installed at each device and a height of an iron tower may be reduced.

Also, because a DC manner has loss less than that of an AC manner when the same power is transmitted, the HVDC transmission system has an advantage of high transmission efficiency. Also, because a DC current is more than two times an AC current in power transmission capacity, the HVDC transmission system has an advantage of a superior power transmission capacity. Meanwhile, the HVDC transmission system may reduce a usage amount of cables and an area of a transmission line to cause effectiveness, and may improve stability of a system by connecting two AC systems having different voltages and frequencies to each other. Further, the HVDC transmission system has no limitation to a transmission distance and may transmit power in a cost-effective manner when transmitting electric power in a main land over 450Km or under the sea over 40Km.

RU 2 563 331 C1 and JP 2009 246249 A disclose background art apparatuses and methods for power loss prediction.

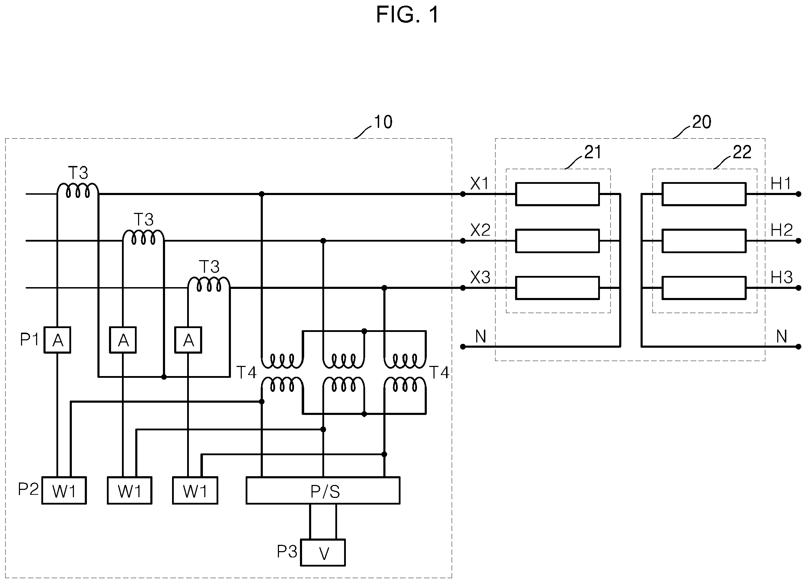

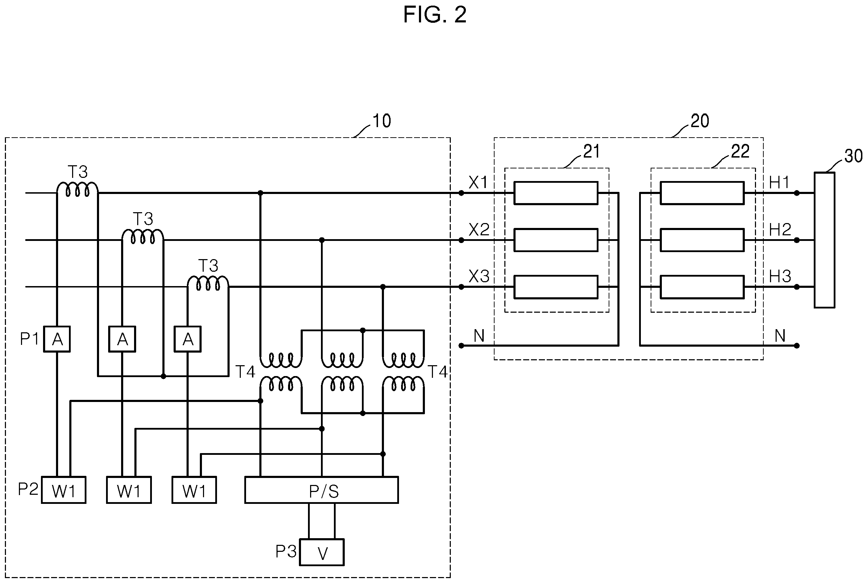

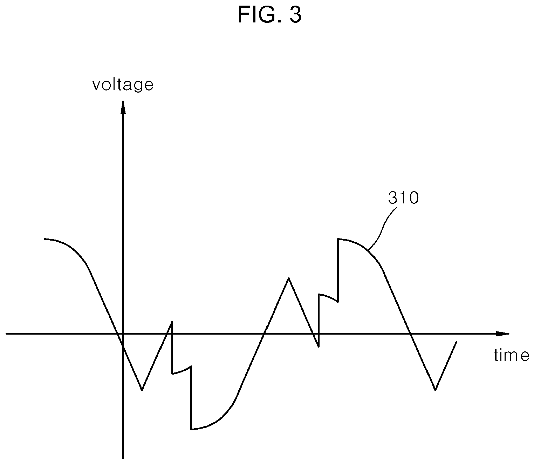

FIG. 1 is a diagram illustrating a case in which a conventional power loss predicting apparatus 10 measures loss of a no-load, and FIG. 2 is a diagram illustrating a case in which the conventional power loss predicting apparatus 10 measures load loss. FIG. 3 is a graph illustrating a voltage waveform 310 applied to a conventional transformer 20. Referring to FIGS. 1 to 3, the conventional transformer 20 is a transformer 20 used in an HVDC transmission system, and the voltage waveform 310 shown in FIG. 3 should be applied to a secondary winding 22. At this point, the load 30 may be a conversion system and a voltage of a sine form should be converted into and output as a DC voltage in the conversion system so that the voltage waveform 310 shown in FIG. 3 should be applied to the secondary winding 22.

When the voltage waveform 310 is applied, the conventional power loss predicting apparatus 10 measures no-load loss when the load 30 is not connected to the second winding 22 and load loss when the load 30 is connected thereto. Thereafter, the conventional power loss predicting apparatus 10 adds the no-load loss to the load loss to predict power loss.

However, according to the conventional power loss predicting apparatus 10, it is difficult to apply the voltage waveform 310 shown in FIG. 3 to the secondary winding of the transformer 20 so that there is a problem in that prediction of power loss is difficult. Also, according to the conventional power loss predicting apparatus 10, prediction of power loss is difficult so that there is a problem in that it is difficult to effectively manage an electric power system. Further, according to the conventional power loss predicting apparatus 10, a sinusoidal wave having a constant magnitude and a constant frequency cannot be applied to the secondary winding 22 of the transformer 20 so that there is a problem in that it is difficult to accurately calculate power loss.

### SUMMARY

An object of the present disclosure is to provide an apparatus for predicting power loss of a transformer, which is capable of power loss by comparing temperature data of the transformer with reference data thereof.

Also, another object of the present disclosure is to provide an apparatus for predicting power loss of a transformer, which is capable of accurately predicting power loss by predicting the power loss on the basis of a winding temperature of the transformer, an insulating oil temperature thereof, and an ambient temperature thereof.

Further, still another object of the present disclosure is to provide an apparatus for predicting power loss of a transformer, which is capable of determining whether the transformer is normal or abnormal by comparing temperature data of the transformer with reference data thereof.

Moreover, yet another object of the present disclosure is to provide an apparatus for predicting power loss of a transformer, which is capable of effectively managing an electric power system by predicting power loss of the transformer.

The objects of the present disclosure are not limited to the above described object, and other objects and advantages not mentioned above will be understood in the art from the following description and also will be apparently understood by an embodiment of the present disclosure. Also, it will be easily understood that the objects and advantages of the present disclosure described herein may be implemented by means and a combination thereof defined by the appended claims.

To attain the above described objects, an apparatus for predicting power loss of a transformer is defined by the claims.

As described above, in accordance with the present disclosure, there is an effect capable of predicting power loss by comparing temperature data of a transformer with reference data thereof.

Also, in accordance with the present disclosure, there is an effect capable of accurately predicting power loss by predicting the power loss on the basis of a winding temperature of a transformer, an insulating oil temperature thereof, and an ambient temperature thereof.

Further, in accordance with the present disclosure, there is an effect capable of determining whether a transformer is normal or abnormal by comparing temperature data of the transformer with reference data thereof.

Moreover, in accordance with the present disclosure, there is an effect capable of effectively managing an electric power system by predicting power loss of a transformer.

### BRIEF DESCRIPTION OF DRAWINGS

FIG. 1 is a diagram illustrating a case in which a conventional power loss predicting apparatus measures a no-load loss.
FIG. 2 is a diagram illustrating a case in which the conventional power loss predicting apparatus measures load loss.
FIG. 3 is a graph illustrating a voltage waveform applied to a conventional transformer.
FIG. 4 is a diagram illustrating a power loss predicting apparatus of a transformer according to one embodiment of the present disclosure.
FIG. 5 is a diagram illustrating a transformer according to one embodiment of the present disclosure.
FIG. 6 is a diagram illustrating a case in which reference data is calculated according to one embodiment of the present disclosure.
FIG. 7 is a graph illustrating a winding temperature and an insulating oil temperature according to one embodiment of the present disclosure.
FIG. 8 is a table illustrating power loss according to an increase of temperature.
FIG. 9 is a table illustrating power loss according to a decrease of slope.

### DETAILED DESCRIPTION

The above and other objects, features and advantages of the present disclosure will be described later in detail with reference to the accompanying drawings, and thus the technical spirit of the present disclosure can be easily implemented by those skilled in the art. In the following description of the present disclosure, if a detailed description of known configurations and functions is determined to obscure the interpretation of embodiments of the present disclosure, the detailed description thereof will be omitted. Hereinafter, preferred embodiments according to the present disclosure will be described in detail with reference to the accompanying drawings. In the drawings, the same reference numerals refer to the same or similar elements throughout.

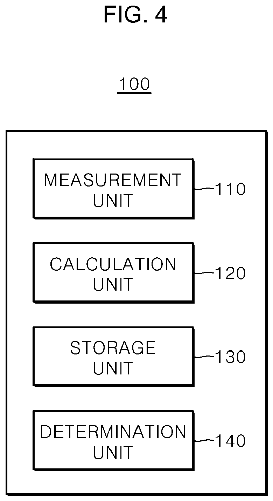

FIG. 4 is a diagram illustrating a power loss predicting apparatus 100 of a transformer according to one embodiment of the present disclosure. Referring to FIG. 4, the power loss predicting apparatus 100 of a transformer according to one embodiment of the present disclosure may be configured to include a measurement unit 110, a calculation unit 120, a storage unit 130, and a determination unit 140. The power loss predicting apparatus 100 of a transformer shown in FIG. 4 is merely directed to one embodiment, components thereof are not limited to the embodiment shown in FIG. 4, and some components may be added, changed, or omitted as necessary.

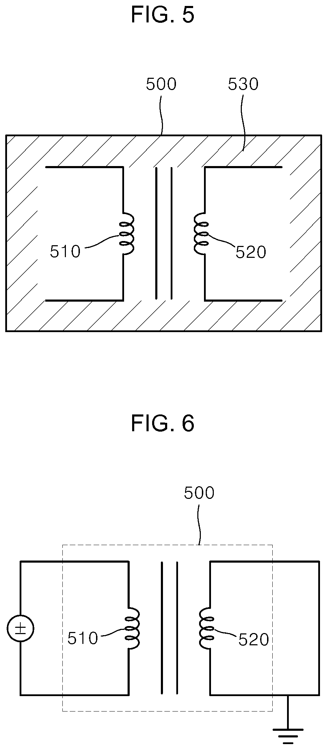

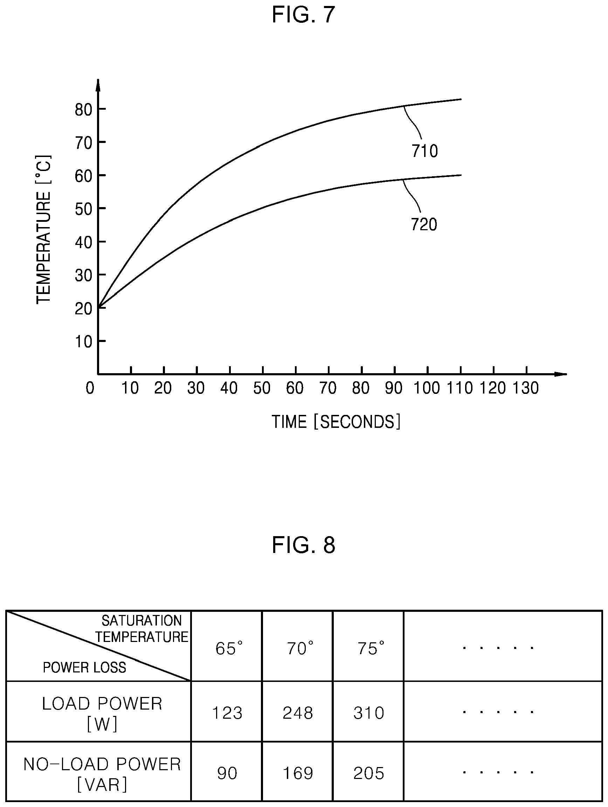

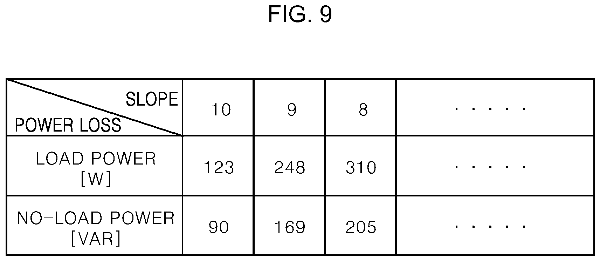

FIG. 5 is a diagram illustrating a transformer 500 according to one embodiment of the present disclosure, and FIG. 6 is a diagram illustrating a case in which reference data is calculated according to one embodiment of the present disclosure. FIG. 7 is a graph illustrating a winding temperature 710 and an insulating oil temperature 720 according to one embodiment of the present disclosure, FIG. 8 is a table illustrating power loss according to an increase of temperature, and FIG. 9 is a table illustrating power loss according to a decrease of slope. Hereinafter, the power loss predicting apparatus 100 of a transformer according to one embodiment of the present disclosure will be described with reference to FIGS. 4 to 9.

The measurement unit 110 according to one embodiment of the present disclosure may measure a temperature of the transformer 500. Here, the transformer 500 may be a transformer 500 used in a high voltage direct current (HVDC) transmission system. A temperature of the transformer 500 may include a winding temperature 710 of the transformer 500, an insulating oil temperature 720 thereof, and an ambient temperature thereof. A winding 510 refers to a coil inside the transformer 500, and insulating oil 530 is a medium for insulating the transformer 500 from peripherals and may exist in a form of liquid inside the transformer 500. The ambient temperature of the transformer 500 refers to an outside temperature of the transformer 500, but not to an inside temperature thereof.

As one embodiment, the measurement unit 110 may include one or more of a winding temperature indicator, a liquid thermometer, and an optical sensor. Referring to FIG. 5, the winding temperature 710 of the transformer 500 may be measured when the measurement unit 110 is a winding temperature indicator, and the insulating oil temperature 720 may be measured when the measurement unit 110 is a liquid thermometer. Also, an ambient temperature of the transformer 500 may be measured when the measurement unit 110 is an optical sensor. The determination unit 140 determines power loss of the transformer 500 using the winding temperature 710 of the transformer 500, the insulating oil temperature 720 thereof, and the ambient temperature of the transformer 500 thereof, which are measured at the measurement unit 110, and this will be described below.

The calculation unit 120 according to one embodiment of the present disclosure may calculate temperature data of the transformer 500 on the basis of a temperature of the transformer 500, which is measured by the measurement unit 110. More particularly, the temperature data may include a saturation temperature and a temperature slope. Here, the saturation temperature may be a temperature of the transformer 500 when a measured temperature variation rate of the transformer 500 and an ambient temperature variation rate thereof are in a predetermined range. Also, when a measured temperature of the transformer 500 is varied according to a time, the temperature slope may be a variation rate of the measured temperature according to a time.

For example, when an insulating oil temperature of the transformer 500 and an ambient temperature thereof are measured as a temperature of the transformer 500, and a variation rate of the insulating oil temperature per hour and a variation rate of the ambient temperature per hour are equal to or less than 1°C, the temperature of the transformer 500 may be a saturation temperature. Meanwhile, a temperature slope may be a value in which a temperature of the transformer 500 being varied when the transformer 500 is powered is differentiated with respect to a time or a temperature variation amount with respect to a regular time interval. For example, a temperature slope may include a temperature variation rate according to a time interval during which a temperature of 10% to 30% of a saturation temperature is measured, and a regular time interval may be set by a user as necessary.

The storage unit 130 according to one embodiment of the present disclosure may set and store reference data of the transformer 500, and the reference data may include power loss according to the above described temperature data. Here, the power loss may include no-load power and load power. The no-load power is power loss in a state in which a load is not connected to the transformer 500, and the load power is power loss in a state in which a load is connected to the transformer 500.

The storage unit 130 may set reference data on the basis of a temperature of the transformer 500, which is varied according to a supply of electric power to a primary circuit of the transformer 500. More particularly, when the storage unit 130 sets reference data, a short circuit method in which a secondary circuit of the transformer 500 is short circuited and power is supplied to a primary circuit thereof may be used. Referring to FIG. 6, a secondary coil 520 of the transformer 500 may be short circuited and then a current may be supplied to a primary coil 510 of the transformer 500. At this point, a temperature of the transformer 500 may rise as the current is supplied, and the storage unit 130 may set power loss according to a slope of a temperature rising as reference data.

Referring to FIG. 7, the winding temperature 710 of the transformer 500 and the insulating oil temperature 720 thereof according to a time may be measured using a short circuit method. As the measurement result, it can be seen that the winding temperature 710 and the insulating oil temperature 720 rise as a time is passed. Because the winding 510 is metal and the insulating oil 530 is liquid, a temperature rising rate of the insulating oil 530 may be less than that of the winding 510. As such, the storage unit 130 may increase accuracy of the reference data by repeating a process of measuring a temperature of the transformer 500 to set reference data.

Referring to FIG. 9, a slope, which is temperature data, may be a variation rate of temperature according to a time interval during which a temperature of 10% to 30% of a saturation temperature is measured.

When a temperature slope of the winding temperature 710 of the transformer 500 is 5, the storage unit 130 may set reference data to power loss of the transformer 500, in which load power of the power loss is set to 123W and no-load power thereof is set to 90VAR. Meanwhile, when a temperature slope of the insulating oil temperature 720 of the storage unit 130 is 3, the storage unit 130 may set reference data to power loss of the transformer 500, in which load power of the power loss is set to 310W and no-load power thereof is set to 205VAR.

Also, the storage unit 130 may determine that the transformer 500 is saturated when the temperature variation rate of the transformer 500 and the ambient temperature variation rate thereof are within a preset range. At this point, the storage unit 130 may set reference data on the basis of a temperature of the saturated transformer 500. For example, when power is supplied to a primary circuit by means of a short circuit method, a temperature variation rate of the transformer 500 is decreased according to a time. At this point, when a temperature variation rate of a transformer 500 per hour and an ambient temperature variation rate per hour are equal to or less than 1°C, the storage unit 130 may determine that the transformer 500 is saturated. Consequently, the storage unit 130 may set power loss according to a temperature of the saturated transformer 500 as reference data.

Referring to FIG. 8, a saturation temperature of the winding temperature 710 of the transformer 500 may be 80°C, and a saturation temperature of the insulating oil temperature 720 may be 80°C. At this point, when a saturation temperature of the winding temperature 710 is 80°C, the storage unit 130 may set reference data as power loss of the transformer 500, in which load power is set to 310W and no-load power is set to 205VAR. Meanwhile, when a saturation temperature of the insulating oil temperature 720 is 60°C, the storage unit 130 may set reference data as power loss of the transformer 500, in which load power is set to 123W and no-load power is set to 90VAR. The storage unit 130 may further include a separate database, and may transmit reference data to the determination unit 140.

The determination unit 140 according to one embodiment of the present disclosure may determine power loss of the transformer 500 by comparing temperature data with reference data. As one embodiment, temperature data may include a saturation temperature, and the determination unit 140 may compare the saturation temperature with reference data to determine power loss of the transformer 500. Referring to FIG. 8, when a measured saturation temperature of the transformer 500 is 70°C, the determination unit 140 may determine power loss of the transformer 500 as load power of 248W and no-load power of 169VAR using reference data set in the storage unit 130.

Also, the temperature data may include a temperature slope and the determination unit 140 may determine the power loss of the transformer 500 by comparing the temperature slope with the reference data. Referring to FIG. 9, when a measured temperature slope of the transformer 500 is 4, the determination unit 140 may determine the power loss of the transformer 500 as the load power of 248W and the no-load power of 169VAR using the reference data set in the storage unit 130.

Meanwhile, the determination unit 140 may determine whether the transformer 500 is normal or abnormal by comparing the temperature data with the reference data. More particularly, when the transformer 500 is abnormal, a temperature variation rate may be abruptly increased or decreased when being normal. When a temperature variation rate of a transformer 500 is outside a normal range, the determination unit 140 may determine that the transformer 500 is abnormal. For example, when a temperature variation rate measured at the measurement unit 110 is outside a normal range based on the temperature variation rate shown in FIG. 7, the determination unit 140 may determine that the transformer 500 is abnormal. On the other hand, when the temperature variation rate measured at the measurement unit 110 is within the normal range based on the temperature variation rate shown in FIG. 7, the determination unit 140 may determine that the transformer 500 is normal. The normal range which is a determination criterion of the determination unit 140 may be set as necessary by a user.

Meanwhile, a power loss predicting method according to one embodiment of the present disclosure is such that power is firstly supplied to a primary circuit of a transformer and a secondary circuit thereof is short circuited to calculate reference data of the transformer. At this point, the reference data may include power loss with respect to a saturation temperature of the transformer and a temperature slope thereof, and the power loss may include no-load power and load power. After the reference data of the transformer is calculated, a storage unit may store the reference data in a database.

Thereafter, a measurement unit measures a temperature of the transformer. At this point, the temperature of the transformer may include a winding temperature of the transformer, an insulating oil temperature thereof, and an ambient temperature thereof. After the temperature of the transformer is measured, a calculation unit calculates temperature data of the transformer on the basis of the measured temperature. Here, the temperature data may include a saturation temperature and a temperature slope. After the temperature data of the transformer is calculated, a determination unit compares the temperature data with reference data to determine power loss of the transformer. For example, the determination unit may determine the power loss of the transformer by comparing the saturation temperature with the reference data, or by comparing the temperature slope with the reference data.

Meanwhile, the determination unit may determine whether the transformer is normal or abnormal by comparing the temperature data with the reference data. Because an inspection for maintenance of the transformer is performed once a half year, the determination unit may determine whether the transformer is normal or abnormal by comparing the temperature data with the reference data once a half year.

In accordance with the present disclosure described above, there may be an effect in which power loss is predictable by comparing temperature data of a transformer with reference data thereof. Also, in accordance with the present disclosure, there is an effect in which power loss is accurately predictable by predicting the power loss on the basis of a winding temperature of a transformer, an insulating oil temperature thereof, and an ambient temperature thereof.

Further, in accordance with the present disclosure, there is an effect in which abnormality of a transformer is determinable by comparing temperature data of the transformer with reference data thereof. Moreover, in accordance with the present disclosure, there is an effect in which power loss of a transformer is predictable to effectively manage an electric power system.

## Claims

1. An apparatus (100) configured for predicting power loss of a transformer (500) comprising a winding and insulating oil, the apparatus comprising a measurement unit (110), a calculation unit (120), a storage unit (130), and a determination unit (140),
**characterized in,**
**that** the measurement unit (110) comprises a winding temperature indicator, a liquid thermometer, and an optical sensor, the measurement unit being configured to measure a temperature of the winding and the insulating oil of the transformer and an ambient temperature of the transformer (500), wherein the ambient temperature of the transformer is a temperature of an outer portion of the transformer (500);
**that** the storage unit (130) is configured to set and store reference data, wherein the reference data includes the power loss dependent upon a saturation temperature and a temperature slope of the transformer, wherein the power loss includes no-load power and load power, wherein the saturation temperature is a temperature of the transformer when a variation rate of the temperature of the winding or the insulating oil and a variation rate of the ambient temperature are within a preset range;
**that** the calculation unit (120) is configured to calculate temperature data of the transformer, the temperature data including the saturation temperature and the temperature slope of the transformer, wherein the temperature slope is the variation rate of the temperature of the winding, the insulating oil, or the optical sensor according to time; and
**that** the determination unit (140) is configured to determine the power loss of the transformer by comparing the temperature data with the reference data.

2. The apparatus of claim 1, wherein the storage unit (130) sets the reference data on the basis of a temperature of the transformer, which is varied according to a supply of electric power to a primary circuit of the transformer.

## Patentansprüche

1. Vorrichtung (100), die zum Vorhersagen des Leistungsverlustes eines Transformators (500) konfiguriert ist, der eine Wicklung und ein Isolieröl umfasst, wobei die Vorrichtung eine Messeinheit (110), eine Berechnungseinheit (120), eine Speichereinheit (130) und eine Bestimmungseinheit (140) umfasst,
**dadurch gekennzeichnet,**
**dass** die Messeinheit (110) eine Wicklungstemperaturanzeige, ein Flüssigkeitsthermometer und einen optischen Sensor umfasst, wobei die Messeinheit konfiguriert ist, um eine Temperatur der Wicklung und des Isolieröls des Transformators und eine Umgebungstemperatur des Transformators (500) zu messen, wobei die Umgebungstemperatur des Transformators eine Temperatur eines Außenabschnitts des Transformators (500) ist;
**dass** die Speichereinheit (130) konfiguriert ist, um Referenzdaten einzustellen und zu speichern, wobei die Referenzdaten die Verlustleistung in Abhängigkeit von einer Sättigungstemperatur und einem Temperaturanstieg des Transformators beinhalten, wobei die Verlustleistung Leerlaufleistung und Lastleistung beinhaltet, wobei die Sättigungstemperatur eine Temperatur des Transformators ist, wenn eine Änderungsrate der Temperatur der Wicklung oder des Isolieröls und eine Änderungsrate der Umgebungstemperatur innerhalb eines vorgegebenen Bereichs liegen;
**dass** die Berechnungseinheit (120) konfiguriert ist, um Temperaturdaten des Transformators zu berechnen, wobei die Temperaturdaten die Sättigungstemperatur und den Temperaturanstieg des Transformators beinhalten, wobei der Temperaturanstieg die Änderungsrate der Temperatur der Wicklung, des Isolieröls oder des optischen Sensors gemäß der Zeit ist; und
**dass** die Bestimmungseinheit (140) konfiguriert ist, um die Verlustleistung des Transformators durch Vergleichen der Temperaturdaten mit den Referenzdaten zu bestimmen.

2. Vorrichtung nach Anspruch 1, wobei die Speichereinheit (130) die Referenzdaten basierend auf einer Temperatur des Transformators einstellt, die entsprechend einer elektrischen Energiezufuhr zu einem Primärkreis des Transformators variiert wird.

## Revendications

1. Appareil (100) configuré pour prédire une perte de puissance d'un transformateur (500) comprenant un enroulement et une huile isolante, l'appareil comprenant une unité de mesure (110), une unité de calcul (120), une unité de stockage (130) et une unité de détermination (140),
**caractérisé en ce que**
l'unité de mesure (110) comprend un indicateur de température d'enroulement, un thermomètre pour liquide et un capteur optique, l'unité de mesure étant configurée pour mesurer une température de l'enroulement et de l'huile isolante du transformateur ainsi qu'une température ambiante du transformateur (500), dans lequel la température ambiante du transformateur est une température d'une partie externe du transformateur (500) ;
l'unité de stockage (130) est configurée pour établir et stocker des données de référence, dans lequel les données de référence comprennent la perte de puissance en fonction d'une température de saturation et d'une courbe de température du transformateur, dans lequel la perte de puissance comprend la puissance sans charge et la puissance de charge, dans lequel la température de saturation est une température du transformateur lorsqu'un taux de variation de la température de l'enroulement ou de l'huile isolante et un taux de variation de la température ambiante se trouvent dans une plage préétablie ;
l'unité de calcul (120) est configurée pour calculer des données de température du transformateur, les données de température comprenant la température de saturation et la courbe de température du transformateur, dans lequel la courbe de température est le taux de variation de la température de l'enroulement, de l'huile isolante ou du capteur optique en fonction du temps ; et
l'unité de détermination (140) est configurée pour déterminer la perte de puissance du transformateur en comparant les données de température aux données de référence.

2. Appareil selon la revendication 1, dans lequel l'unité de stockage (130) établit les données de référence sur la base d'une température du transformateur, qui varie selon une alimentation électrique fournie à un circuit primaire du transformateur.
